# EUROPÄISCHE PATENTSCHRIFT

(11) **EP 0 755 160 B1**
(45) Veröffentlichungstag und Bekanntmachung des Hinweises auf die Patenterteilung: **10.10.2001**
(21) Anmeldenummer: 96201952.7
(22) Anmeldetag: 11.07.1996
(51) Int. Cl.: H04N 9/78

(54) **Kammfilteranordnung**
Comb filter device
Circuit de filtre en peigne

(30) Priorität: 15.07.1995 DE 19525804
(43) Veröffentlichungstag der Anmeldung: 22.01.1997
(73) Patentinhaber: Philips Corporate Intellectual Property GmbH, 52064 Aachen (DE); Koninklijke Philips Electronics N.V., 5621 BA Eindhoven (NL)
(72) Erfinder: Bartels, Cord-Heinrich, Philips Patentverw. GmbH, 22335 Hamburg (DE); Suwald, Thomas, Philips Patentverwaltung. GmbH, 22335 Hamburg (DE); Struck, Sönke, Philips Patentverwaltung. GmbH, 22335 Hamburg (DE); Wölber, Jörg, Philips Patentverwaltung. GmbH, 22335 Hamburg (DE)
(74) Vertreter: von Laue, Hanns-Ulrich, Dipl.-Ing.

(56) Entgegenhaltungen:
- DE-A- 4 242 201
- US-A- 4 727 415
- ELECTRONIC COMPONENTS & APPLICATIONS, 1990, NETHERLANDS, Bd. 9, Nr. 4, ISSN 0141-6219, Seiten 194-207, XP000671137 BRUNS E ET AL: "Analog multi-standard colour decoder ICs TDA4650 and TDA4660"
- IEEE INTERNATIONAL SOLID STATE CIRCUITS CONFERENCE, Bd. 36, 1.Februar 1993, Seiten 30-31, 257, XP000388013 NISHIMURA K A ET AL: "A MONOLITHIC ANALOG VIDEO COMB FILTER IN 1.2UM CMOS*"
- PROCEEDINGS OF THE INTERNATIONAL CONFERENCE ON CONSUMER ELECTRONICS, ROSEMONT, JUNE 8 - 10, 1993, Nr. CONF. 12, 8.Juni 1993, INSTITUTE OF ELECTRICAL AND ELECTRONICS ENGINEERS, Seite 178/179 XP000427576 VOLMARI F ET AL: "SWITCHED-CAPACITOR CIRCUITS FOR ANALOG VIDEO SIGNAL PROCESSING"
- BBC RESEARCH AND DEVELOPMENT REPORT, TADWORTH, SURREY, GB, Nr. 11, November 1988, Seiten 1-25, XP000001214 CLARKE C K P: "PAL DECODING: MULTI-DIMENSIONAL FILTER DESIGN FOR CHROMINANCE - LUMINANCE SEPARATION"

## Beschreibung

Die Erfindung betrifft eine Kammfilteranordnung mit zwei Signalzweigen, die jeweils wenigstens eine Verzögerungsanordnung aufweisen und denen eingangsseitig ein einem Träger aufmoduliertes Videosignal zugeführt wird, wobei die Ausgangssignale der Signalzweige einem Addierer zugeführt werden und wobei die Verzögerungsanordnungen in Switched-Capacitor-Technik aufgebaut sind

Derartige Kammfilteranordnungen nach dem Stande der Technik sind z.B. für PAL-Signale meist so ausgelegt, daß das Eingangssignal der Kammfilteranordnung einem Eingang des Addierers unverzögert und einem zweiten Eingang um die Dauer zweier Bildzeilen verzögert zugeführt wird. Hierzu ist es erforderlich, daß die Verzögerungszeit für dieses zweite Signal den vorgegebenen Wert erfüllt. Aus Herstellungsgründen der Verzögerungsanordnung weist diese jedoch oft nicht den gewünschten Wert, nämlich die Dauer zweier Bildzeilen, auf. Für Videosignale der NTSC-Norm weisen die dem Addierer zugeführten Signale relativ zueinander eine Verzögerung um die Dauer einer Bildzeile des Videosignals auf. Auch hier ist der Nachteil gegeben, daß dieser Wert nicht immer genau eingehalten werden kann.

Ein Beispiel für eine derartige Kammfilteranordnung sind die für Videorekorder vorgesehenen Kammfilteranordnungen zur Ausfilterung des Farbsignals. Eine derartige Anordnung ist beispielsweise aus Grundig Technische Informationen 3-84, Seiten 144-150, bekannt. Die Anordnung dient dazu, ein von einem Videoband ausgelesenes PAL-Farbsignal von übersprechenden Farbsignalen benachbarter Spuren zu befreien. Auch die aus dieser Veröffentlichung bekannte Kammfilteranordnung ist so aufgebaut, daß das Eingangssignal einem Eingang eines Addierers unverzögert und einem zweiten Eingang um die Dauer zweier Bildzeilen verzögert zugeführt wird.

Auch diese Anordnung weist den oben beschriebenen Nachteil auf, daß die einzige Verzögerungsanordnung einen vorgegebenen Verzögerungswert aufweisen muß.

In derartigen bekannten Kammfilteranordnungen ist die vorgesehene Verzögerungsanordnung als Glasverzögerungsleitung, als CCD (Charge-Coupled-Devices-) Verzögerungsleitung oder als digitale Verzögerungsleitung aufgebaut.

Aus dem Dokument ELECTRONIC COMPONENTS & APPLICATIONS, 1990, NETHERLANDS, Bd. 9, Nr. 4, ISSN 0141-6219, Seiten 194-207 (BRUNS E ET AL: "Analog multi-standard colour decoder ICs TDA 4650 and TDA 4660" ist ein Farbdekoder bekannt, der Kammfilteranordnungen beinhaltet. Diese Kammfilteranordnungen besitzen zwei Signalpfade, wobei jeweils einer dieser Signalpfade eine Verzögerungsanordnung besitzt. Die Ausgangssignale des verzögerten und des nicht verzögerten Signals werden mittels eines gesonderten Addierers addiert. Die Verzögerungsanordnungen sind dabei in Switched-Capacitor-Technik aufgebaut.

Aus US-A-4 727 415 ist eine Kammfilteranordnung mit unterschiedlichen Verzögerungszeiten für die beiden Zweige bekannt. Diese werden dazu eingesetzt, räumlich benachbarte Abtastwerte eines Videosignals zur Y/C-Filterung zu verwenden.

Aus DE 42 42 201 A ist ferner eine Schaltungsanordnung zum Verzögern eines Nutzsignals bekannt, bei der ebenfalls die Switched-Capacitor-Technik eingesetzt wird. Aus dieser Veröffentlichung sind frei konfigurierbare Verzögerungszeiten für Verzögerungsanordnungen bekannt.

Es ist Aufgabe der Erfindung, eine Kammfilteranordnung der eingangs genannten Art dahingehend weiterzuentwickeln, daß sie möglichst einfach aufgebaut ist, und ein möglichst genaues zeitliches und amplitudenmäßiges Matching der überlagerten Signale der beiden Zweige erzielt wird.

Diese Aufgabe ist erfindungsgemäß dadurch gelöst, daß wenigstens eines der dem Addierer zugeführten Videosignale in der Weise mittels der Verzögerungsanordnungen zeitlich verzögert wird, daß der relative zeitliche Versatz der beiden dem Addierer zugeführten Videosignale ein ganzzahliges Vielfaches der Dauer einer Bildzeile des Videosignals plus/minus der Dauer eines ganzzahligen Vielfachen der Dauer einer Periode der Trägerfrequenz beträgt und daß die Verzögerungsanordnungen Speicherkapazitäten aufweisen, deren Speicherwerte auf eine für beide Verzögerungsanordnungen gemeinsam vorgesehene Ausleseleitung auslesbar sind, auf der sie sich beim Auslesevorgang additiv überlagern, so daß die Ausleseleitung den Addierer darstellt.

Der Aufbau der Verzögerungsanordnungen in Switched-Capacitor-Technik bedeutet, daß Speicherkapazitäten vorgesehen sind, in die Abtastwerte der zu verzögernden Signale eingelesen werden. Nach der gewünschten Verzögerungszeit werden die Abtastwerte wieder aus den Speicherzellen ausgelesen. Für die erfindungsgemäße Kammfilteranordnung bietet die erfindungsgemäße Anwendung der Switched-Capacitor-Technik darüber hinaus die Möglichkeit, für die Speicherkapazitäten beider Verzögerungsanordnungen eine gemeinsame Ausleseleitung vorzusehen. Es wird damit Schaltungsaufwand eingespart. Auf der gemeinsamen Ausleseleitung überlagern sich beim Auslesevorgang die aus den Speicherkapazitäten ausgelesenen Werte beider Verzögerungsanordnungen. Damit übernimmt die Ausleseleitung die Funktion des Addierers. Damit ist ein separater Addierer nicht erforderlich. Dadurch wird außerdem ein sehr genaues zeitliches und amplitudenmäßiges Matching der Signale erzielt, so daß keine gesonderten Matching-Maßnahmen erforderlich sind. Die Gesamtlaufzeit wird dadurch verkürzt, daß kein gesonderter Addierer in dem Signalpfad vorhanden ist.

Bei den bekannten Kammfilteranordnungen wird immer davon ausgegangen, daß eine orthogonale Kämmung vorgenommen werden muß. Dies bedeutet für PAL-Signale, daß die beiden dem Addierer zugeführten Signal relativ zueinander um die Dauer zweier Bildzeilen verzögert sein müssen. Für NTSC-Signale beträgt dieser Wert die Dauer einer Bildzeile. Der Erfindung liegt die Erkenntnis zugrunde, daß eine derartige orthogonale Filterung tatsächlich nicht erforderlich ist. Es werden nahezu identische Filterergebnisse erzielt, wenn eine sogenannte nicht orthogonale Kämmung vorgenommen wird. Dabei kann der Verzögerungswert das ganzzahlige Vielfache der Bildzeilen (das von der Übertragungsnorm abhängt) um ein ganzzahliges Vielfaches der Dauer einer Periode der Farbträgerschwingung überschreiten oder unterschreiten. Dies bedeutet, daß die in der Kammfilteranordnung vorgesehene Verzögerungsanordnung nicht genau eine Verzögerung um ein ganzzahliges Vielfaches der Dauer einer Bildzeile des Videosignals vornehmen muß. Vielmehr kann eine Abweichung hiervon zugelassen werden, die jedoch so gewählt sein muß, daß die obengenannte Bedingung der relativen Verzögerung der beiden dem Addierer zugeführten Videosignale eingehalten wird. Der Vorteil besteht vor allem darin, daß fertigungstechnisch derartige Kammfilteranordnungen mit Verzögerungsanordnungen, die eine geringere Verzögerungszeit als die Dauer des ganzzahligen Vielfachen einer Bildzeile aufweisen, erheblich einfacher ist.

Gemäß einer Ausgestaltung der Erfindung ist vorgesehen, daß beide dem Addierer zugeführten Videosignale mittels jeweils einer Verzögerungsanordnung verzögert werden und daß die relative Verzögerung der beiden dem Addierer zugeführten Signale so gewählt ist, daß die Ausgangssignale der Verzögerungsanordnung relativ zueinander um ein ganzzahliges Vielfaches der Dauer einer Bildzeile des Videosignals plus/minus der Dauer eines ganzzahligen Vielfachen der Dauer einer Periode der Trägerfrequenz verzögert sind.

Es sind zwei Verzögerungsanordnungen vorgesehen, deren Verzögerungszeiten so ausgelegt sind, daß die Differenz der Zeiten die gewünschte relative Verzögerung um ein ganzzahliges Vielfaches der Dauer einer Bildzeile des Videosignals plus/minus der Dauer eines ganzzahligen Vielfachen einer Periode der Trägerschwingung ergibt. Dabei sind die Verzögerungszeiten der beiden Verzögerungsanordnungen so zu wählen, daß sich die Signale mit der gewünschten Phasenlage in dem Addierer überlagern.

Beispielsweise für ein Fernsehsignal, das einmal in unverzögerter und einmal um die Dauer zweier Bildzeilen verzögert in dem Addierer überlagert werden soll, besteht nicht die Erfordernis, daß eine der Verzögerungsanordnungen eine Verzögerung von zwei Bildzeilen liefern muß. Sie kann vielmehr eine abweichende Verzögerung liefern, dann ist jedoch die andere Verzögerungseinrichtung bezüglich ihrer Verzögerungszeit so auszugestalten, daß die beiden Ausgangssignale sich wieder mit der gewünschten Verzögerungszeit überlagern.

Gemäß einer weiteren Ausgestaltung der Erfindung ist vorgesehen, daß es sich bei dem Videosignal um ein solches der PAL-Übertragungsnorm handelt und daß die Verzögerung beiden dem Addierer zugeführten Videosignale relativ zueinander um die Dauer zweier Bildzeilen des Videosignals plus/minus der Dauer eines ganzzahligen Vielfachen der Dauer einer Periode der Trägerfrequenz beträgt.

Für Videosignale nach der PAL-Übertragungsnorm wird bei dieser Bedingung der relativen Verzögerung der beiden dem Addierer zugeführten Signale die oben erläuterte nicht orthogonale Kämmung erzielt.

Für Videosignale der NTSC-Übertragungsnorm muß jedoch eine andere Bedingung gelten. Daher ist für derartige Signale gemäß einer weiteren Ausgestaltung der Erfindung vorgesehen, daß die beiden dem Addierer zugeführten Videosignale relativ zueinander um die Dauer einer Bildzeile des Videosignals plus/minus der Dauer eines ganzzahligen Vielfachen der Dauer einer Periode der Farbträgerfrequenz zueinander verschoben sind.

Dabei ist vorgesehen, daß beide Verzögerungsanordnungen Speicherkapazitäten aufweisen, deren Speicherwerte auf eine für beide Verzögerungsanordnungen gemeinsam vorgesehene Ausleseleitung auslesbar sind, auf der sie sich beim Auslesevorgang additiv überlagern, so daß die Ausleseleitung den Addierer darstellt.

Der Aufbau der Verzögerungsanordnungen in Switched-Capacitor-Technik bedeutet, daß Speicherkapazitäten vorgesehen sind, in die Abtastwerte der zu verzögernden Signale eingelesen werden. Nach der gewünschten Verzögerungszeit werden die Abtastwerte wieder aus den Speicherzellen ausgelesen. Für die erfindungsgemäße Kammfilteranordnung bietet die erfindungsgemäße Anwendung der Switched-Capacitor-Technik darüber hinaus die Möglichkeit, für die Speicherkapazitäten beider Verzögerungsanordnungen eine gemeinsame Ausleseleitung vorzusehen. Es wird damit Schaltungsaufwand eingespart. Auf der gemeinsamen Ausleseleitung überlagern sich beim Auslesevorgang die aus den Speicherkapazitäten ausgelesenen Werte beider Verzögerungsanordnungen. Damit übernimmt die Ausleseleitung die Funktion des Addierers. Damit ist ein separater Addierer nicht erforderlich.

Gemäß einer weiteren Ausgestaltung der Erfindung ist vorgesehen, daß jeder Speicherkapazität ein Auslesetransistor zugeordnet ist, mittels dessen eine in der Speicherkapazität gespeicherte Ladung auf die Ausleseleitung auslesbar ist, daß an einer Kompensationsleitung Kompensationstransistoren der gleichen Anzahl, Verschaltung an der Leitung und Bauart wie Auslesetransistoren an der Ausleseleitung vorgesehen sind, und daß ein Verstärker vorgesehen ist, auf dessen nichtinvertierenden Eingang die Ausleseleitung und auf dessen invertierenden Eingang die Kompensationsleitung gekoppelt ist und der ausgangsseitig das kammgefilterte Signal liefert.

Durch diese Anordnung können die insbesondere kapazitiven Einflüsse der Auslesetransistoren, die den Speicherkapazitäten zugeordnet sind, kompensiert werden. Damit wird die Signalbeeinflussung, die durch die Kapazitäten der Auslesetransistoren stattfindet, kompensiert.

Gemäß einer weiteren Ausgestaltung der Erfindung ist vorgesehen, daß es sich bei dem der Kammfilteranordnung zugeführten Videosignal um ein einem Farbträger aufmoduliertes Farbsignal, das aus einem Lesesignal eines Videorekorders ausgefiltert ist, handelt.

Für die Aufzeichnung auf Videobändern werden Videosignale verschiedenen Träger aufmoduliert. Die Farbsignale werden im sogenannten Color-Under-Verfahren relativ niederfrequenten Trägem aufmoduliert. Beim Auslesevorgang einer Spur hat dies zur Folge, daß nicht nur die Farbsignale dieser Spur, sondern auch übersprechende Farbsignale aus Nachbarspuren mit ausgelesen werden. Zur Unterdrückung dieser übersprechenden Farbsignale sind Kammfilteranordnungen bekannt. Diese weisen jedoch die oben beschriebenen Nachteile auf. Es kann daher statt dessen die erfindungsgemäße Kammfilteranordnung vorgesehen werden, wobei für derartige Farbsignale der relative Versatz der beiden dem Addierer zugeführten Signale ein geradzahliges Vielfaches der Dauer einer Bildzeile des Videosignals plus/minus der Dauer eines geradzahligen Vielfachen der Dauer einer Periode der Farbträgerfrequenz betragen muß, damit die Farbsignale sich in der Weise überlagern, daß die übersprechenden Farbsignale unterdrückt werden und sich die Nutz-Farbsignale gleichphasig überlagern. Diese Bedingung kann insbesondere auch dadurch erfüllt werden, daß zwei Verzögerungsanordnungen vorgesehen sind und daß der relative zeitliche Versatz der Ausgangssignale beider Verzögerungsanordnungen dieser Bedingung entspricht. Dazu ist es nicht unbedingt erforderlich, daß der zeitliche Versatz der beiden Signale exakt einem geradzahligen Vielfachen der Dauer einer Bildzeile entspricht. Aufgrund der relativ geringen Auflösung des Farbsignals kann auch ein Versatz um die Dauer eines geradzahligen Vielfachen der Dauer einer Periode der Farbträgerfrequenz zugelassen werden, ohne daß dieser Versatz im Bild sichtbar wird.

Für eine derartige Kammfilteranordnung ist gemäß weiteren Ausgestaltungen der Erfindung vorgesehen, daß das Farbsignal zur Verarbeitung in der bzw. den Verzögerungsanordnung(en) zuvor mit einem Abtasttakt abgetastet wird, der ein ganzzahliges Vielfaches, wenigstens jedoch das Zweifache der doppelten Farbträgerfrequenz beträgt bzw. daß der Abtasttakt das Vierfache der Farbträgerfrequenz beträgt.

Um die oben genannte Phasenbeziehung einhalten zu können, ist es vorteilhaft, wenn der Abtasttakt des Farbsignals ein ganzzahliges Vielfaches der Farbträgerfrequenz beträgt. Es ist dann möglich, die oben genannte relative zeitliche Beziehung der beiden Signale zueinander relativ leicht einzuhalten, da die Verzögerungszeiten das Vierfache dieses Abtasttaktes betragen.

Beispielsweise ein Videosignal der PAL-Norm, das auf einem Videoband aufgezeichnet wurde, wird zur Aufzeichnung wie oben beschrieben in der Weise vorverarbeitet, daß das Leuchtdichtesignal bzw. das Farbsignal verschiedenen Trägern mit verschiedenen Frequenzen aufmoduliert werden. Ein solchermaßen vorverarbeitetes Signal wird nach dem Lesen dieses Signals in das Leuchtdichtesgnal und das Farbsignal getrennt. Nach dieser Ausfilterung kann das Farbsignal vorteilhaft in der erfindungsgemäßen Kammfilteranordnung von Nachbarspuren übersprechenden Farbsignalen befreit werden. Dabei beträgt der zeitliche Versatz der beiden dem Addierer zugeführten Signale das Zweifache der Dauer einer Bildzeile des Videosignals plus/minus eines geradzahligen Vielfachen der Dauer einer Periode der Farbträgerfrequenz.

In entsprechender Weise ist für NTSC-Signale vorgesehen, daß der relative zeitliche Versatz der beiden dem Addierer zugeführten Signale das Einfache der Dauer einer Bildzeile des Videosignals plus/minus der Dauer eines geradzahligen Vielfachen der Dauer einer Periode der Farbträgerfrequenz beträgt.

Eine weitere Ausgestaltung der Erfindung sieht vor, daß eine erste Verzögerungsanordnung, die das Farbsignal um die Dauer zweier Bildzeilen abzüglich der Dauer einer halben Periode des Farbträgers verzögert, und eine zweite Verzögerungsanordnung vorgesehen ist, die das Farbsignal um die Dauer einer halben Periode des Farbträgers verzögert, und daß die Ausgangssignale der beiden Verzögerungsanordnungen dem Addierer zugeführt werden.

Beispielsweise aus Gründen der Herstellung gibt es Verzögerungsanordnungen, die nicht in der Lage sind, eine Verzögerung der ihr zugeführten Signale um genau die Dauer zweier Bildzeilen des Videosignals vorzunehmen. In diesem Falle kann eine bekannte Verzögerungsanordnung, die das Farbsignal um die Dauer zweier Bildzeilen abzüglich der Dauer einer halben Periode des Farbträgers verzögert, eingesetzt werden. Würde allerdings das Ausgangssignal dieser Verzögerungsanordnung mit dem unverzögerten Eingangssignal der Kammfilteranordnung (wie nach dem Stande der Technik) addiert werden, so würden sich die Signale nicht in gewünschter Phasenlage überlagern. Daher ist erfindungsgemäß eine zweite Verzögerungsanordnung vorgesehen, die das Farbsignal um die Dauer einer halben Periode des Farbträgers verzögert. Damit ist wiederum gewährleistet, daß sich die Signale mit der erforderlichen Phasenlage im Addierer überlagern.

Eine Kammfilteranordnung gemäß der Erfindung kann vorteilhaft in einem Videorekorder vorgesehen sein, dort insbesondere zur wiedergabeseitigen Ausfilterung von von Nachbarspuren übersprechenden Farbsignalen.

Nachfolgend wird ein Ausführungsbeispiel der Erfindung anhand der Zeichnung näher erläutert. Es zeigen:
Fig. 1 eine schematische Darstellung eines auf einem Band aufgezeichneten Videosignals mit von Zeile zu Zeile des Bildes und von Spur zu Spur des Bandes wechselnden Phasenlagen des aufgezeichneten Videosignals und
Fig. 2 eine Kammfilteranordnung zur Unterdrückung von Farbsignalen, die in ein Farbsignal, das von einem Band eines Videorekorders ausgelesen wurde, übersprechen.

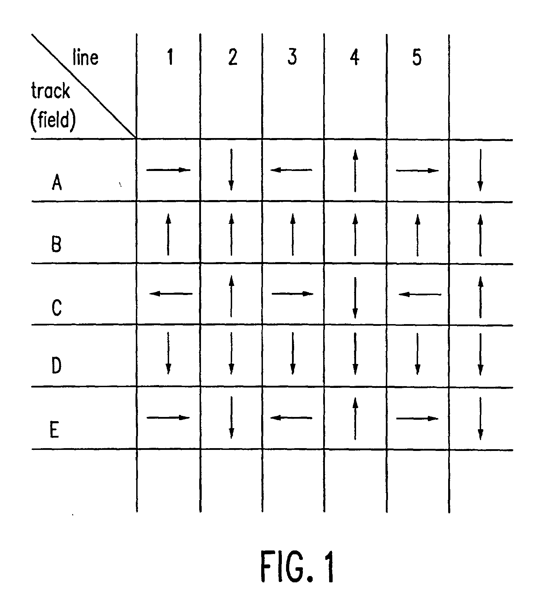

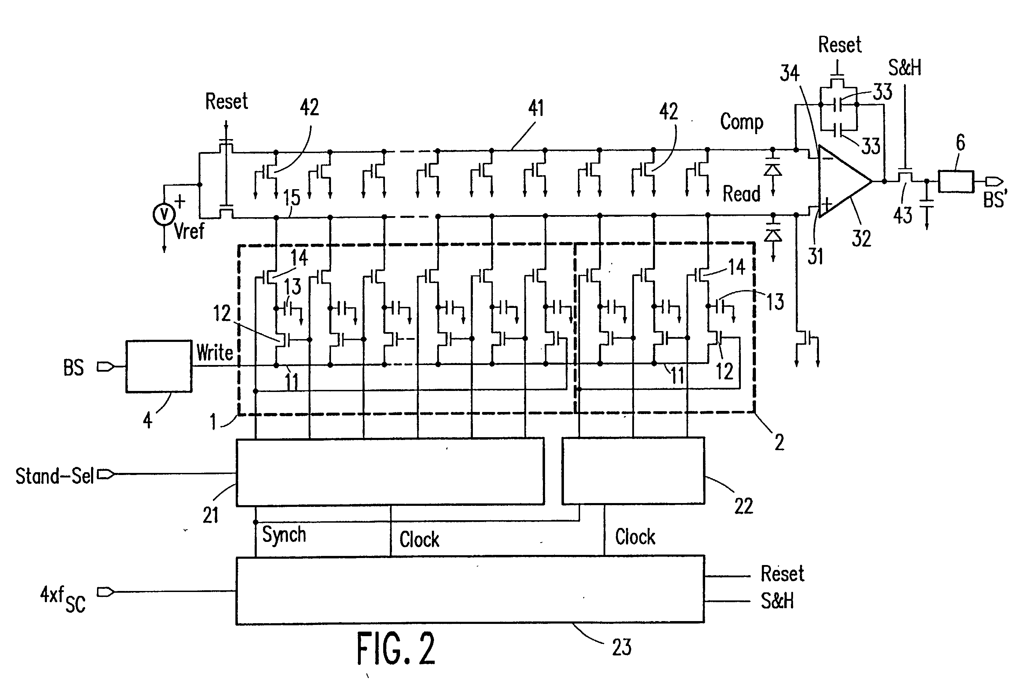

Im folgenden soll anhand der Darstellung gemäß Fig. 1 die Problematik bei Videorekordern erläutert werden, aufgrund derer beim Lesen eines Videosignals bzw. Farbsignals von einer bestimmten Spur eines Bandes Farbsignale aus Nachbarspuren übersprechen. Die Anordnung gemäß Fig. 2 dient zur Unterdrückung dieser übersprechenden Farbsignale.

Fig. 1 zeigt eine schematische Darstellung, in der zeilenweise fünf Halbbilder A, B, C, D und E schematisch in einer Weise dargestellt sind, wie sie beispielsweise auf einem Videoband aufgezeichnet werden können. Es sind ferner fünf Zeilen angedeutet, in denen jeweils durch die dargestellte Anordnung eines Pfeiles die Phasenlage des aufgezeichneten Signales symbolisiert werden soll.

Die im folgenden betrachteten Phasenlagen des Signals beziehen sich auf die Phasenlage des Farbsignals relativ zu der Phasenlage des Farbträgers. Damit sind zusätzliche Umtastungen der Phasenlänge des Farbträgers, wie sie in einigen Farbübertragungssystemen vorgesehen sind, bei dieser Betrachtung unberücksichtigt.

Beispielsweise für die Aufzeichnung eines PAL-Signals auf Geräten der VHS-Norm ist es vorgesehen, daß in jedem zweiten Halbbild die Phasenlage des Farbsignals von Zeile zu Zeile um jeweils 90° weitergeschaltet wird. Damit treten aufeinanderfolgend Phasenlagen von 0°, 90°, 180°, 270°, 0°, 90° usw. auf. Dies ist beispielsweise in den Zeilen der Spuren A, C und E der Darstellung gemäß Fig. 1 der Fall. In den übrigen Spuren bleibt für alle Zeilen die Phasenlage erhalten, jedoch wird in diesen übrigen Spuren von Spur zu Spur zwischen 0° und 180° Phasenlage umgeschaltet. Dies zeigen beispielsweise die Zeilen der Spuren B und D der Darstellung gemäß Fig. 1.

Wird beispielsweise die Zeile 3 des Halbbildes B ausgelesen, so ist ein Kammfilter konventioneller Weise so ausgelegt, daß das Signal B3 und das Signal B1, also ein um die Dauer zweier Bildzeilen verzögertes Signal additiv überlagert werden. Die Darstellung gemäß Fig. 1 zeigt, daß die Nutzsignale B3 und B1 sich tatsächlich in gleicher Phasenlage überlagern.

Gleichzeitig tritt jedoch beim Lesen des Signals B3 ein Übersprechen der Nachbarsignale A3 und C3 auf. Durch die Überlagerung mit dem zuvor gelesenen Signal B1, in das die Signale A1 und C1 übersprechen, ergibt sich jedoch aufgrund der Phasenlage der übersprechenden Signale eine Auslöschung dieser Signale. Das übersprechende Signal A3 weist Gegenphase zu dem übersprechenden Signal A1 auf, so daß diese beiden Signale sich aufheben. Entsprechendes gilt für die Signale C3 und C1.

Wird beispielsweise ein Signal der Bildzeile C gelesen, so gilt Entsprechendes. Dabei ist zu berücksichtigen, daß die ursprünglich vorgenommene Weiterschaltung der Phasenlage von Zeile zu Zeile um jeweils 90° in dem Auslesesignal rückgängig gemacht wird. Damit überlagern sich die Auslesesignale beispielsweise von C3 und C1 wiederum gleichphasig. Infolge der Rückgängigmachung dieser Phasenumschaltung sind dann jedoch die übersprechenden Signale B1 und B3 gegenphasig. Entsprechendes gilt für die übersprechenden Signale D3 und D1.

Bei dieser Erläuterung der Darstellung gemäß Fig. 1 wurde davon ausgegangen, daß die beiden zu überlagernden Signale relativ zueinander genau um die Dauer zweier Zeilen verzögert sind. Dies ist jedoch tatsächlich nicht erforderlich, da das Farbsignal mit relativ geringer Auflösung bzw. Übertragungsbandbreite behaftet ist. Es genügt daher, daß die beiden überlagerten Farbsignale in dem Beispielsfalle des PAL-Signals relativ zueinander um die Dauer zweier Bildzeilen plus/minus eines geradzahligen Vielfachen der Dauer einer Periode des Farbträgersignals zueinander zeitlich versetzt sind. Es werden dann zwar nicht die Farbinformationen der gleichen Bildpunkte zweier Bildzeilen überlagert, dies fällt jedoch aufgrund der oben genannten Bandbreitenbedingung nicht ins Gewicht. Entscheidend ist jedoch, daß die in dem Farbträger aufmodulierten Farbsignale in gleicher Phasenlage überlagert werden. Damit ist sichergestellt, daß die übersprechenden Farbsignale mit gegensätzlicher Phasenlage überlagert werden und sich somit auslöschen.

In Fig. 2 ist ein Ausführungsbeispiel einer Kammfilteranordnung dargestellt, bei dem diese Sachverhalte genutzt wurden. Es sind dort zwei Verzögerungsanordnungen 1 und 2 in der Kammfilteranordnung vorgesehen, wobei die erste Verzögerungsanordnung 1 eine Verzögerung um die Dauer zweier Bildzeilen abzüglich der Dauer einer halben Periode der Frequenz des Farbträgersignals aufweist und bei der die zweite Verzögerungsanordnung 2 das ihr zugeführte Signal um die Dauer einer halben Periode der Frequenz des Farbträgers verzögert. Im Gegensatz zu den Anordnungen nach dem Stande der Technik ist hier also keine Verzögerungsanordnung erforderlich, die exakt eine Verzögerung um die Dauer zweier Bildzeilen vornimmt. Aus technologischen Gründen sind vielmehr Verzögerungsanordnungen verfügbar, die eine Verzögerungszeit entsprechend der ersten Verzögerungsanordnung aufweisen. Erfindungsgemäß ist daher die zweite Verzögerungsanordnung vorgesehen, mittels der die additiv überlagerten Signale bezüglich ihrer Phasenlage wieder so zueinander eingestellt werden, daß sich die oben gewünschten Überlagerungseffekte der übersprechenden Farbsignale ergeben.

Beide Verzögerungsanordnungen 1 und 2 sind in einer sogenannten Switched-Capicator-Technik aufgebaut, d.h. daß den Bildsignalen Abtastwerte entnommen werden, die in Speicherkapazitäten eingelesen werden. Nach einer vorgegebenen Verzögerungszeit werden diese in den Speicherkapazitäten abgespeicherten Ladungen wieder auf eine Ausleseleitung ausgelesen. In dem Ausführungsbeispiel gemäß Fig. 2 ist dabei, wie noch näher zu erläutern sein wird, für beide Verzögerungsanordnungen 1 und 2 eine gemeinsame Ausleseleitung 15 vorgesehen, die die Funktion des Addierers übernimmt.

Die Darstellung gemäß Fig. 2 zeigt, daß das der Kammfilteranordnung eingangsseitig zugeführte Bildsignal zunächst dem Filter 4 zugeführt wird, dessen Ausgangssignal auf die erste Verzögerungsanordnung 1 und die zweite Verzögerungsanordnung 2 gelangen.

Für diese beiden Verzögerungsanordnungen ist eine gemeinsame Schreibleitung 11 vorgesehen. Jede der Verzögerungsanordnungen weist eine bestimmte Zahl von Verzögerungselementen auf, deren Anzahl von dem gewählten Abtasttakt sowie der jeweils für die Verzögerungsanordnungen 1 bzw. 2 gewünschten Verzögerungszeit abhängt.

Jedes Verzögerungselement weist einen Schreibtransistor 12, der eingangsseitig mit der Einleseleitung 11 verbunden ist, auf. Ferner weist jedes Verzögerungselement eine Speicherkapazität 13 auf, die einerseits mit dem Schreibtransistor 12 und andererseits mit einem Auslesetransistor 14 verbunden ist. Die Auslesetransistoren 14 aller Verzögerungselemente der beiden Verzögerungsanordnungen 1 und 2 arbeiten ausgangsseitig auf eine gemeinsame Ausleseleitung 15.

Die Ansteuerung der Schreibtransistoren 12 sowie der Auslesetransistoren 14 wird mittels Steuereinrichtungen 21 bzw. 22 vorgenommen.

Die Steuereinrichtung 21 steuert die Verzögerungsanordnung 1. Dabei werden immer gemeinsam ein Einlesetransistor einer Speicherzelle n sowie der Auslesetransistor der nachfolgenden Speicherzelle n+1 angesprochen.

Für die Dauer der Verzögerungszeit, mit der das Bildsignal in der Verzögerungsanordnung 1 verzögert wird, ist der Übertragungsstandard des Bildsignals BS zu berücksichtigen. Dafür wird der Steueranordnung 21 ein Signal STAND_SEL zugeführt, das den Übertragungsstandard des Bildsignals angibt. Beispielsweise für ein PAL-Bildsignal ist entsprechend dem oben erläuterten für die gewünschte Phasenbeziehung der beiden überlagerten Signale eine Verzögerungszeit von zwei Bildzeilen des Bildsignals abzüglich der Dauer einer halben Periode der Farbträgerschwingung vorgesehen. Die Steueranordnung 21 steuert dann die Schreib- bzw. Lesetransistoren 12 bzw. 14 in entsprechender Weise bzw. berücksichtigt die benötigte Anzahl von Speicherelementen.

Den Steueranordnungen 21 und 22 wird jeweils ein Taktsignal, das in der Fig. 2 mit CLOCK bezeichnet ist, sowie ein Synchronisationssignal, das mit SYNC bezeichnet ist, zugeführt. Dieses Signal wird von einem Taktgenerator 23 geliefert. Das Taktsignal CLOCK dient insbesondere dazu, den Steueranordnungen 21 bzw. 22 diejenigen Zeitpunkte anzugeben, zu denen aus einer Speicherzelle n ein Wert in die Speicherkapazität 13 dieser Zelle eingelesen und zu denen gleichzeitig aus der Speicherkapazität 13 der dahinter angeordneten Speicherzelle n+1 der in dieser Kapazität gespeicherte Ladungswert auf die Ausleseleitung 15 ausgelesen wird. Durch dieses getaktete Einlesen in die Speicherkapazitäten 13 findet quasi eine Abtastung des Bildsignals BS statt. In dem in Fig. 2 dargestellten Ausführungsbeispiel beträgt dieser Abtasttakt und damit die Frequenz des Signals CLOCK das Vierfache der Frequenz der Farbträgerschwingung. Die Wahl dieser Frequenz ist deshalb vorteilhaft, da dann, wie noch näher zu erläutern sein wird, die Einstellung der erforderlichen Phasenbeziehungen der Ausgangssignale der beiden Verzögerungsanordnungen 1 und 2 relativ leicht einzustellen ist.

Die Steueranordnung 21 steuert die ihr zugeordneten Speicherelemente der Verzögerungsanordnung in der Weise, daß entsprechend diesem Abtasttakt Proben des Bildsignals BS entnommen werden und nacheinander in die Speicherkapazität 13 verschiedener Speicherelemente der Speicheranordnung 1 eingelesen werden. Durch die Verkopplung der Steuerleitungen der Einlesetransistoren 12 mit dem jeweils der nachfolgenden Speicherzelle vorgesehenen Auslesetransistor 14 findet gleichzeitig ein Auslesevorgang der in den Speicherkapazitäten 13 gespeicherten Daten auf die Ausleseleitung 15 statt. Die Zahl der Speicherelemente bzw. die Zahl der mittels der Steueranordnung 21 aktivierten Speicherelemente bestimmt dabei die Verzögerungszeit des Bildsignals, das in Form von Abtastwerten auf die Ausleseleitung 15 gelangt. Die Verzögerung dieser Abtastwerte auf die Ausleseleitung 15 ausgegebenen Bildsignals relativ zu dem Eingangssignal auf der Einleseleitung 11 beträgt die Dauer zweier Bildzeilen des Bildsignals abzüglich der Dauer einer halben Periode der Farbträgerschwingung.

Die Steueranordnung 22 steuert in entsprechender Weise die in der Verzögerungsanordnung 2 vorgesehenen Speicherelemente. Entsprechend dem oben erläuterten soll diese zweite Verzögerungsanordnung eine Verzögerung des ihr zugeführten Bildsignals um eine halbe Periodendauer vornehmen. Bei dem gewählten Abtasttakt, der das Vierfache der Farbträgerschwingung beträgt, bedeutet dies, daß eine Verzögerung des Bildsignals um die Dauer zweier Abtasttakte vorzunehmen ist. Eine solche Verzögerung kann genau mit drei Speicherelementen, die in der Verzögerungsanordnung 2 vorgesehen sind, erzielt werden.

Aufgrund der oben erläuterten Phasenbeziehungen der Ausgangssignale der Verzögerungsanordnung 1 sowie der Verzögerungsanordnung 2 überlagern sich die aus den Speicherkapazitäten 13 beider Verzögerungsanordnungen ausgelesenen Abtastwerte des Bildsignals auf der gemeinsamen Ausleseleitung 15 in einer solchen Phasenlage, daß die Schwingungen des Farbträgers, dem die Farbsignale aufmoduliert sind, sich in Gegenphase befinden. Dies hat zur Folge, daß eine Auslöschung der Farbträger bzw. damit des Farbsignals stattfindet. Es wird bei der Anordnung gemäß Fig. 2 durch die Wahl dieser Phasenbeziehung ein gesonderter Addierer eingespart; vielmehr fungiert die Ausleseleitung 15 quasi als Addierer.

Die Ausleseleitung 15 ist mit einem nichtinvertierenden Eingang 31 eines Operationsverstärkers 32 verbunden. Der Operationsverstärker 32 ist extern mit einem Rückkopplungsnetzwerk verschaltet, das die nichtlinearen Eigenschaften der Speicherkapazitäten 13 kompensiert. In dem Rückkopplungsnetzwerk sind dazu zwei Kapazitäten 33 vorgesehen, welche jeweils die gleichen Eigenschaften aufweisen wie eine Speicherkapazität 13 der Speicheranordnungen 1 und 2. Es sind in dem Rückkopplungsnetzwerk zwei Kapazitäten 33 dieser Eigenschaft erforderlich, da jeweils zwei Speicherkapazitäten 13 der Verzögerungsanordnungen 1 und 2 gleichzeitig auf die Ausleseleitung 15 geschaltet werden. Dieses Rückkopplungsnetzwerk ist ausgangsseitig mit einem invertierenden Eingang 34 des Operationsverstärkers 32 verbunden.

Es ist ferner eine Kompensationsleitung 41 vorgesehen, mit der Kompensationstransistoren 42 verbunden sind. Diese Kompensationstransistoren 42 haben gleiche Anzahl und gleiche Eigenschaften wie die Transistoren 14 der Verzögerungsanordnungen 1 und 2. Der Zweck der Kompensationsleitung 41 und der mit ihr verbundenen Kompensationstransistoren 42 ist der, die Einflüsse, die die mit der Ausleseleitung 15 verbundenen Transistoren 14 auf ein auf diese Ausleseleitung ausgelesenes Signal haben, zu kompensieren. Ein aus einer Speicherkapazität 13 der Verzögerungsanordnung 1 oder 2 ausgelesenes Signal wird insbesondere durch die kapaziviten Einflüsse dieser Auslesetransistoren 14 beeinflußt. Diese Signalbeeinflussung wird durch die Kompensationstransistoren 42 und die Kompensationsleitung 41, die mit dem invertierenden Eingang des Operationsverstärkers 32 verbunden sind, kompensiert.

Das Ausgangssignal des Verstärkers 32, in dem aufgrund der oben erläuterten Phasenbeziehung das Farbsignal unterdrückt ist, gelangt auf eine Sample and Hold-Stufe 43, die in der Darstellung gemäß Fig. 2 symbolisch mit einem Transistor gekennzeichnet ist. Die einzelnen Abtastwerte, die aus den Transistoren 13 der beiden Verzögerungsanordnungen 1 und 2 ausgelesen, die nachfolgend über den Operationsverstärker 32 auf die Sample and Hold-Stufe 43 gelangen, werden hier für eine vorgegebene Zeit auf einem konstanten Wert gehalten. Es ist nachfolgend das Filter 6 vorgesehen, das das treppenförmige Ausgangssignal der Sample and Hold-Stufe 43 wieder glättet. Das Filter 6 liefert ausgangsseitig das Ausgangssignal der Kammfilteranordnung, das in der Fig. 2 mit BS' gekennzeichnet ist.

Anstelle der einen niederohmigen Ausgang (Spannungsausgang) aufweisenden Operationsverstärker können auch sogenannte OTAs (Operational Transconductance Amplifier) eingesetzt werden, welche einen hochohmigen Ausgang (Stromausgang) aufweisen.

Die Anordnung gemäß Fig. 2 arbeitet abgleichfrei, ist leicht integrierbar und hat darüber hinaus den Vorteil, daß sie einen insgesamt sehr einfachen Aufbau aufweist, da die Kammfilterfunktion hier ohne besondere Addierer oder auch Subtrahierer möglich ist und daß das zu verarbeitende Signal BS' einer geringstmöglichen Verzögerung unterworfen wird.

## Patentansprüche

1. Kammfilteranordnung mit zwei Signalzweigen, die jeweils wenigstens eine Verzögerungsanordnung aufweisen und denen eingangsseitig ein einem Träger aufmoduliertes Videosignal zugeführt wird, wobei die Ausgangssignale der Signalzweige einem Addierer zugeführt werden und wobei die Verzögerungsanordnungen in Switched-Capacitor-Technik aufgebaut sind,
**dadurch gekennzeichnet,**
**daß** wenigstens eines der dem Addierer zugeführten Videosignale in der Weise mittels der Verzögerungsanordnungen zeitlich verzögert wird, daß der relative zeitliche Versatz der beiden dem Addierer zugeführten Videosignale ein ganzzahliges Vielfaches der Dauer einer Bildzeile des Videosignals plus/minus der Dauer eines ganzzahligen Vielfachen der Dauer einer Periode der Trägerfrequenz beträgt und daß die Verzögerungsanordnungen Speicherkapazitäten aufweisen, deren Speicherwerte auf eine für beide Verzögerungsanordnungen gemeinsam vorgesehene Ausleseleitung auslesbar sind, auf der sie sich beim Auslesevorgang additiv überlagern, so daß die Ausleseleitung den Addierer darstellt.

2. Kammfilteranordnung nach Anspruch 1, **dadurch gekennzeichnet,**
**daß** es sich bei dem Videosignal um ein solches der PAL-Übertragungsnorm handelt und daß die beiden dem Addierer zugeführten Videosignale relativ zueinander um die Dauer zweier Bildzeilen des Videosignals plus/minus der Dauer eines ganzzahligen Vielfachen der Dauer einer Periode der Trägerfrequenz verzögert sind.

3. Kammfilteranordnung nach Anspruch 1, **dadurch gekennzeichnet,**
**daß** es sich bei dem Videosignal um ein solches der NTSC-Übertragungsnorm handelt und daß die beiden dem Addierer zugeführten Videosignale relativ zueinander um die Dauer einer Bildzeile des Videosignals plus/minus der Dauer eines ganzzahligen Vielfachen der Dauer einer Periode der Trägerfrequenz verschoben sind.

4. Kammfilteranordnung nach Anspruch 1, **dadurch gekennzeichnet,**
**daß** jeder Speicherkapazität ein Auslesetransistor zugeordnet ist, mittels dessen eine in der Speicherkapazität gespeicherte Ladung auf die Ausleseleitung auslesbar ist, daß an einer Kompensationsleitung Kompensationstransistoren der gleichen Anzahl, Verschaltung an der Leitung und Bauart wie Auslesetransistoren an der Ausleseleitung vorgesehen sind, und daß ein Verstärker vorgesehen ist, auf dessen nichtinvertierenden Eingang die Ausleseleitung und auf dessen invertierenden Eingang die Kompensationsleitung gekoppelt ist und der ausgangsseitig das kammgefilterte Signal liefert.

5. Kammfilteranordnung nach einem der Ansprüche 1 bis 4, **dadurch gekennzeichnet,**
**daß** es sich bei dem der Kammfilteranordnung zugeführten Videosignal um ein einem Farbträger aufmoduliertes Farbsignal, das aus einem Lesesignal eines Videorekorders ausgefiltert ist, handelt.

6. Kammfilteranordnung nach Anspruch 5, **dadurch gekennzeichnet,**
**daß** das Farbsignal zur Verarbeitung in der bzw. den Verzögerungsanordnung(en) zuvor mit einem Abtasttakt abgetastet wird, der ein ganzzahliges Vielfaches, wenigstens jedoch das Zweifache der doppelten Farbträgerfrequenz beträgt.

7. Kammfilteranordnung nach Anspruch 6, **dadurch gekennzeichnet,**
**daß** der Abtasttakt das Vierfache der Farbträgerfrequenz beträgt.

8. Kammfilteranordnung nach Anspruch 1, **dadurch gekennzeichnet,**
**daß** eine erste Verzögerungsanordnung, die das Videosignal um die Dauer zweier Bildzeilen abzüglich der Dauer einer halben Periode der Trägerfrequenz verzögert, und eine zweite Verzögerungsanordnung vorgesehen ist, die das Videosignal um die Dauer einer halben Periode der Trägerfrequenz verzögert, und daß die Ausgangssignale der beiden Verzögerungsanordnungen dem Addierer zugeführt werden.

9. Videorekorder mit einer Kammfilteranordnung nach einem der Ansprüche 1 bis 8 zur Ausfilterung von von Nachbarspuren übersprechenden Farbsignalen in ein ein Farbsignal enthaltendes Lesesignal.

## Claims

1. A comb filter arrangement with two signal branches having each at least one delay circuit and to the input of which circuits is applied a video signal modulated on a carrier, while the output signals of the signal branches are applied to an adder and the delay circuits are structured according to the switched-capacitor technique,
**characterized in that** at least one of the video signals applied to the adder is delayed by the delay circuit(s) so that the relative delay of the two video signals applied to the adder is an integral-numbered multiple of the duration of one picture line of the video signal plus or minus the duration of an integral-numbered multiple of the duration of one period of the carrier frequency and **in that** the delay circuits have storage capacitors whose memory values can be read from a read line which is provided in common for the two delay circuits, on which read line the memory values are additionally superimposed during the operation, so that the read line represents the adder.

2. The comb filter arrangement as claimed in Claim 1,
**characterized in that** the video signal is in accordance with the PAL transmission standard and **in that** the two video signals applied to the adder are delayed relative to each other for the duration of two picture lines of the video signal plus or minus the duration of an integral-numbered multiple of the duration of one period of the carrier frequency.

3. A comb filter arrangement as claimed in Claim 1,
**characterized in that** the video signal is in accordance with the NTSC transmission standard and **in that** the two video signals applied to the adder are delayed relative to each other for the duration of one picture line of the video signal plus or minus the duration of an integral-numbered multiple of the duration of one period of the carrier frequency.

4. A comb filter arrangement as claimed in Claim 1,
**characterized in that** each memory capacitor is assigned a read transistor by which a charge stored in the memory capacitor can be read out on the read line,
that compensating transistors of like number, line connection and structure to the read transistors connected to the read line are connected to the compensation line, and **in that** an amplifier is included to whose non-inverting input is coupled the read line and to whose inverting input is coupled the compensation line and which produces the comb-filtered signal on its output.

5. A comb filter arrangement as claimed in Claims 1 to 4,
**characterized in that** the video signal applied to the comb filter arrangement is a color signal modulated on a chrominance carrier, which color signal is filtered from a reading signal of a video recorder.

6. A comb filter arrangement as claimed in Claim 5,
**characterized in that** the color signal is sampled with a sampling clock before it is processed in the delay circuit(s), which clock is an integral-numbered multiple of, but at least twice the double chrominance carrier frequency.

7. A comb filter arrangement as claimed in Claim 6,
**characterized in that** the sampling clock is four times the chrominance carrier frequency.

8. A comb filter arrangement as claimed in Claim 1,
**characterized in that** a first delay circuit delays the video signal for the duration of two picture lines minus the duration of half a period of the carrier frequency, and a second delay circuit delays the video signal for the duration of half a period of the carrier frequency and **in that** the output signals of the two delay circuits are applied to the adder.

9. A video recorder comprising a comb filter arrangement as claimed in one of the Claims 1 to 8 for filtering out color signals caused by crosstalk from adjacent tracks in a reading signal containing a color signal.

## Revendications

1. Circuit de filtre en peigne avec deux branches de signal qui présentent respectivement au moins un dispositif retardateur et auquel est amené côté entrée un signal vidéo modulé sur une porteuse, les signaux de sortie des branches de signal étant amenés à un additionneur et les dispositifs retardateurs étant conçus dans une technique Switched Capacitor,
**caractérisé en ce qu'**au moins un des signaux vidéo amenés à l'additionneur est retardé temporellement à l'aide des dispositifs retardateurs de telle sorte que le décalage temporel relatif des deux signaux vidéo amenés à l'additionneur s'élève à un multiple entier de la durée d'une ligne d'image du signal vidéo plus/moins la durée d'un multiple entier de la durée d'une période de la porteuse et que le dispositif retardateur présente des capacités de mémoire dont les valeurs de mémoire peuvent être lues sur une ligne de lecture prévue commune aux deux dispositifs retardateurs sur laquelle elles se superposent par addition lors de l'opération de lecture si bien que la ligne de lecture constitue l'additionneur.

2. Circuit de filtre en peigne selon la revendication 1,
**caractérisé en ce que** le signal vidéo est un signal de norme transmission PAL et que les deux signaux vidéo amenés à l'additionneur sont retardés l'un par rapport à l'autre de la durée de deux lignes d'image du signal vidéo plus/moins la durée d'un multiple entier de la durée d'une période de la porteuse.

3. Circuit de filtre en peigne selon la revendication 1,
**caractérisé en ce que** le signal vidéo est un signal de la norme de transmission NTSC et que les deux signaux vidéo amenés à l'additionneur sont retardés l'un par rapport à l'autre de la durée d'une ligne d'image du signal vidéo plus/moins la durée d'un multiple entier de la durée d'une période de la porteuse.

4. Circuit de filtre en peigne selon la revendication 1, **caractérisé en ce qu'**à chaque capacité de mémoire est affecté un transistor de lecture à l'aide duquel une charge enregistrée dans la capacité de mémoire peut être lue sur la ligne de lecture, que sur une ligne de compensation sont prévus des transistors de compensation du même nombre, montage sur la ligne et conception que les transistors de lecture sur la ligne de lecture et qu'il est prévu un amplificateur sur l'entrée non inversante duquel la ligne de lecture et sur l'entrée inversante duquel la ligne de compensation est couplée et qui délivre côté sortie le signal filtré en peigne.

5. Circuit de filtre en peigne selon l'une des revendications 1 à 4, **caractérisé en ce que** le signal vidéo amené au circuit de filtre en peigne est un signal de couleur modulé sur une sous-porteuse couleur qui est filtré à partir d'un signal de lecture d'un magnétoscope vidéo.

6. Circuit de filtre en peigne selon la revendication 5, **caractérisé en ce que** le signal de couleur est balayé en vue du traitement dans le ou les dispositifs retardateurs préalablement à un rythme de balayage qui s'élève à un multiple entier mais au moins au double de la double sous-porteuse couleur.

7. Circuit de filtre en peigne selon la revendication 6, **caractérisé en ce que** le rythme de balayage s'élève au quadruple de la fréquence de la sous-porteuse couleur.

8. Circuit de filtre en peigne selon la revendication 1, **caractérisé en ce qu'**un premier dispositif retardateur qui retarde le signal vidéo de la durée de deux lignes d'image moins la durée d'une demi-période de la fréquence porteuse et un deuxième dispositif retardateur qui retarde le signal vidéo de la durée d'une demi-période de la fréquence porteuse sont prévus et que les signaux de sortie des deux dispositifs retardateurs sont amenés à l'additionneur.

9. Magnétoscope vidéo avec un circuit de filtre en peigne selon l'une des revendications 1 à 8 en vue du filtrage de signaux de parole diaphoniques par des pistes voisines en un signal de lecture contenant un signal de couleur.
